Europäisches Patentamt

European Patent Office

Office européen des brevets

(11) Publication number: **0 317 287 B1**

## (12) EUROPEAN PATENT SPECIFICATION

(45) Date of publication of patent specification: **11.11.92** �["51"] Int. Cl.⁵: **H03K 19/173**, H03K 19/177

(21) Application number: **88310813.6**

(22) Date of filing: **16.11.88**

(54) Programmable logic device.

(30) Priority: **20.11.87 JP 293721/87**
**30.06.88 JP 163389/88**

(43) Date of publication of application:
**24.05.89 Bulletin 89/21**

(45) Publication of the grant of the patent:
**11.11.92 Bulletin 92/46**

(84) Designated Contracting States:
**DE FR GB**

(56) References cited:
**EP-A- 0 177 261**
**GB-A- 2 171 546**
**JP-A-61 224 520**

**ELEKTRONIK, vol.36, no. 19, 18th September 1987, pages 30-32, München, DE; H. BIEHEL: "ASICs: Anwenderprogrammierbare CMOS-Gate-Arrays"**

**PROCEEDINGS OF THE IEEE 1987 CUSTOM INTEGRATED CIRCUITS CONFERENCE, Portland, Oregon, 4th-7th May 1987, pages 515-521, IEEE, New York, US; H.-C. HSIEH et al.: "A second generation user-programmable gate array"**

(73) Proprietor: **KAWASAKI STEEL CORPORATION**
**No. 1-28, 1-Chome Kitahonmachi-Dori**
**Chuo-Ku, Kobe-Shi Hyogo 651(JP)**

(72) Inventor: **Keida, Hisaya c/o Technical**
**Research Division Kawasaki Steel Corporation**
**1, Kawasaki-cho Chiba-shi Chiba 260(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

Rank Xerox (UK) Business Services

## Description

The present invention relates to a programmable logic device (hereinafter referred to as "PLD") including a plurality of programmable logic elements (hereinafter referred to "PLE") having a plurality of flip-flop circuits.

There has heretofore been known a PLD in which optional logic circuits are practicably arranged by a user who programs the device himself. For example, as an example, there is the one disclosed in JP-A-61 198 919 and JP-A-61 224 520.

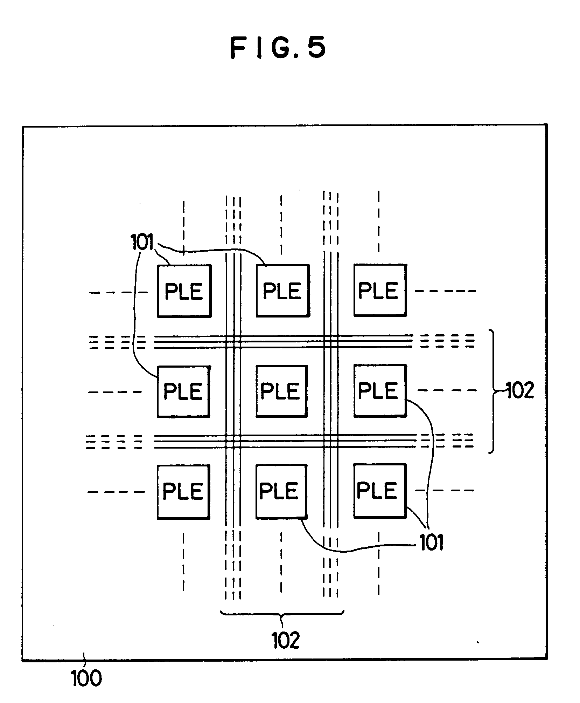

Fig. 5 is a block diagram of a PLD. In this PLD, a plurality of PLEs 101 are provided on a chip 100, and further, input terminals and output terminals of PLEs 101 can be desirably connected to each other by programmable wiring means 102 in vertical and horizontal directions between the terminals.

The PLE 101 has a combinational logic circuit such as a programmable logic array (hereinafter referred to as "PLA") having a programmable AND plane or OR plane, and a table look-up type logic circuit, and may have one or a plurality of flip-flop circuits (hereinafter referred to as "F/F") as necessary.

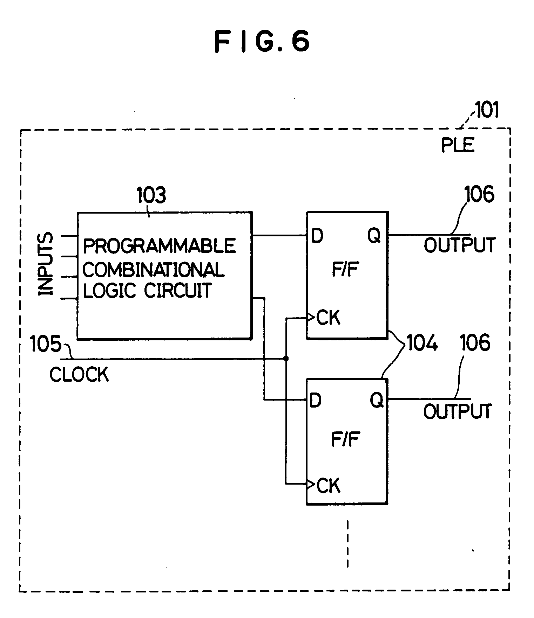

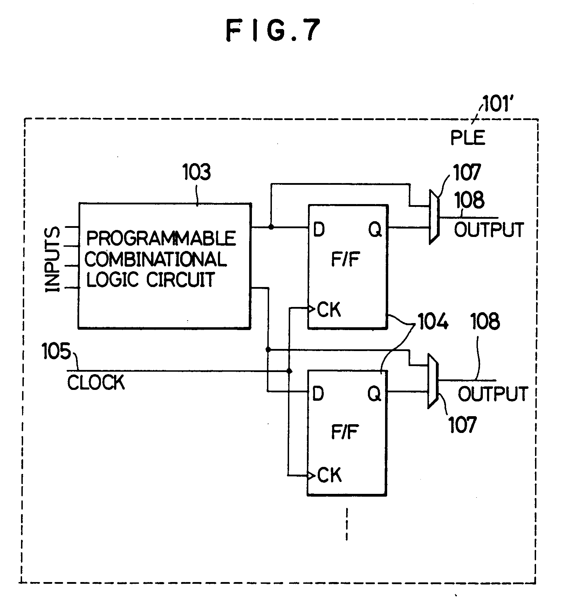

Figs. 6 and 7 are circuit diagrams showing the conventional examples of the PLE 101. In a PLE 101 shown in Fig. 6, output signals from a programmable combinational logic circuit 103 are connected to a plurality of D input terminals of a plurality of F/Fs 104 where the input signals are subjected to a sampling by a clock signal input into a clock input terminal 105, and output terminals 106 of the D-F/Fs 104 are formed to provide output terminals of the PLE 101.

Another PLE 101' shown in Fig. 7 has substantially the same arrangement as that shown in Fig. 6. However, outputs from the programmable combinational logic circuit 103 and outputs from the D-F/F 104 are received by multiplexers 107 as their input signals and the multiplexers 107 selectively output either one of these input signals. Output terminals 108 of the multiplexers 107 are formed to provide output terminals of the PLE 101'.

However, the PLD in the conventional techniques suffers from the following problems.

(1) As shown in Fig. 6, when the outputs of the PLE 101 are obtainable only from the F/Fs 104, if it is desired to obtain outputs directly from the programmable combinational logic circuit 103, the only way do this is to omit the F/F 104. Accordingly, there occurs a case where the PLE 101 having the F/F 104 is not used or not usable.

(2) As shown in Fig. 7, when the aforesaid two outputs are switched over, the problem of the aforesaid Item (1) can be solved, however, the F/F 104 can be used only alternatively, namely used or not used. Accordingly, when the F/F 104s are not used, wastage results. This becomes significant as the number of the F/Fs 104 in the PLE 101' is increased.

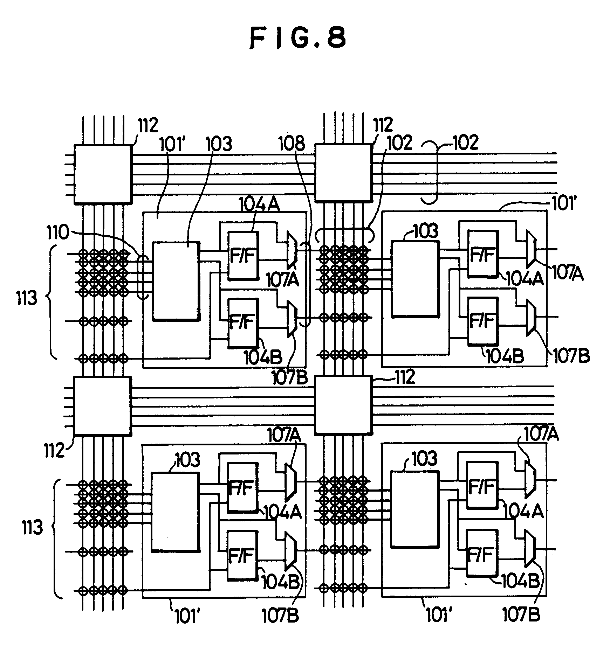

Fig. 8 is a conventional circuit arrangement diagram of the PLD, in which the PLE 101' has a plurality of (two in the drawing) F/Fs 104A and 104B as shown in Fig. 7. This conventional PLD has a plurality of PLEs 101' and programmable wiring 102 disposed in both vertical and horizontal directions. Similarly to that shown in Fig. 7, the PLE 101' comprises:

the programmable combinational logic circuit 103;

the two F/Fs 104A and 104B which receive outputs from this programmable combinational circuit 103 as their inputs; and

the multiplexers 107A and 107B which selectively output to the output terminals 108 either an output signal from outputs from the F/Fs 104A and 104B, or an output signal from the programmable combinational logic circuit 103.

Furthermore, the programmable wirings 102 have;

switch arrays 112 capable of freely connecting respective wirings with each other at points where wirings in vertical and horizontal directions intersect each other; and

input/output switch arrays 113 capable of freely connecting the input terminals 110 and the output terminals 108 of the PLEs 101' to the respective wirings.

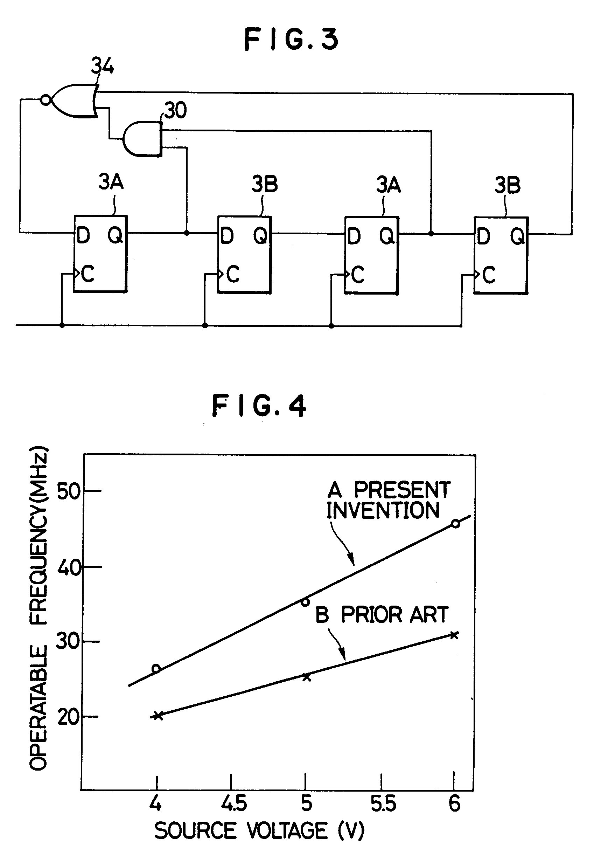

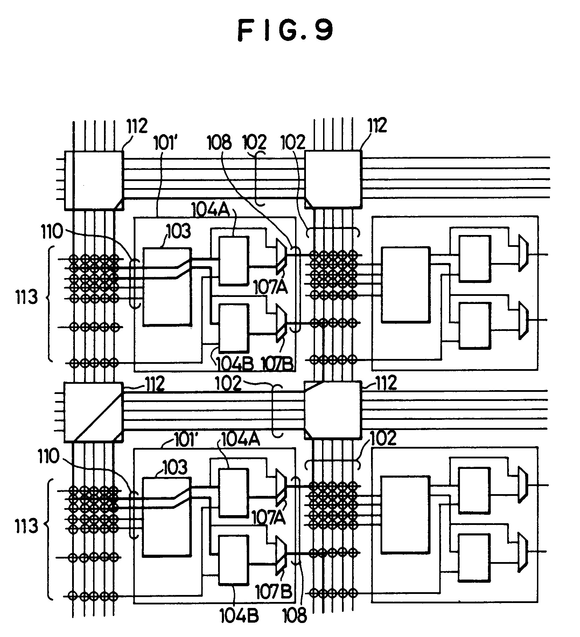

Fig. 9 is a connection diagram of a four bit counter circuit formed by the conventional PLD as shown in Fig. 8. Respective output signals from the F/Fs 104A and 104B of the conventional PLE 101', together with output signals from the programmable combinational logic circuit 103, are passed through the multiplexers 107A and 107B and connected to the output terminals 108 of the PLE 101'. Accordingly, needless to say in a case where an output signal from one 104A of the F/Fs is input into another PLE 101', when it is desired to input the aforesaid output signal into the other 104B of the F/Fs of the same PLE 101', it is necessary to connect through the programmable wirings 102. For this reason, when four F/Fs were connected together to form a four bit counter circuit as shown in Fig. 3, in the past, the connections shown as solid lines in Fig. 9 were necessary. That is, by programming the respective switch arrays 112, the input/output arrays 103, the programmable combinational logic circuits 103 and the multiplexers 107A and 107B, the output terminals 108 of the PLE 101' were respectively connected to the input terminals 110 of the original or another PLE 101', that is, input terminals of the programmable combinational circuits 103.

However, in the conventional PLD, when an output signal of a F/F of a PLE is connected to a F/F of the same or another PLE to form a counter circuit or the like, the output signal of the F/F has to be connected via programmable wirings 102 and the programmable combinational logic circuit 103, which have a relatively long delay time. Accordingly, there has been the problem that the operation frequency is restricted.

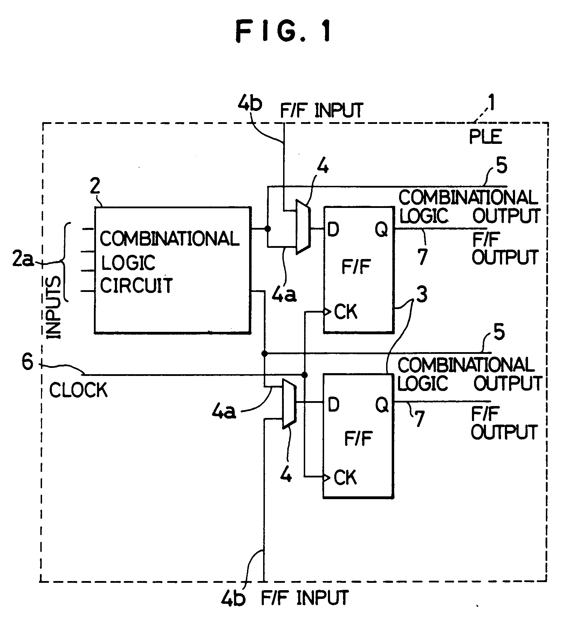

An article in Elektronik, Vol. 36, No. 19, 18th September 1987, p.30 and 31 by H. Biebel discloses a programmable logic element having a combinational logic circuit and two flip-flop circuits each of which has a selecting means for switching either an output of the combinational logic circuit or a data input signal to an input terminal of the flip-flop circuit, the programmable logic element being provided with output terminals connected to outputs of the combinational logic circuit and to outputs of each of the flip-flops. The configuration of this programmable logic element is similar to that of Fig. 1.

The present invention has been developed in view of the above-described disadvantages and embodiments thereof may provide a PLD capable of improving the use efficiencies of F/Fs and a combinational logic circuit included in a PLE.

Embodiments of the present invention may also provide a PLD including a plurality of PLEs each having a plurality of F/Fs, wherein output and input signals of the respective F/Fs are connected to each other, to thereby raise the operation frequency of a realised circuit.

According to the present invention, there is provided a programmable logic device having a plurality of programmable logic elements capable of forming an optional logic circuit by programming of programmable links connecting input terminals and output terminals of said programmable logic elements to each other, wherein:-

said programmable logic elements have a combinational logic circuit; a number N of flip-flop circuits each of which has a selecting means for switching one of either an output of the said combinational logic circuits or an output from another programmable logic element or an output of another flip-flop circuit of the same programmable logic element, to an input terminal of said flip-flop circuit; and said programmable logic elements are provided with output terminals connected to outputs of said combinational logic circuit and output terminals connected to outputs of each of said flip-flops.

In this way, by means of the section for switching inputs into the F/Fs, the output from the combinational logic circuit in one PLE and the output from another PLE can be selected, and the output from the combinational logic circuit is output independently of the outputs from the F/Fs. Either one of the output from the combinational logic circuit and the outputs from the F/Fs are made utilisable by means of external programmable wirings or the like. Therefore, by the selected input and the independent outputs, each of the plurality of F/Fs in the PLE and the combinational logic circuit can be used either independently of each other or interconnectively. Accordingly, in the use of the F/Fs and the combinational logic circuit, high freedom and flexibility are obtainable, thus improving the use efficiencies thereof.

In the present invention, means for selecting one of the signals input into the respective F/Fs is provided, and, by the selection made by this selecting means, output signals from the adjoining F/Fs are input into each other, thus linking the F/Fs in a serial connection. The last F/F of one PLE inputs its output signal into the first F/F of the adjoining PLE through a connecting line specially used by the selecting means of the first F/F of the adjoining PLE, so that a mutual relationship therebetween can be established. As described above, the input and output signals of the F/Fs are directly connected to each other through the selecting means, rather than through programmable wirings or input terminals of the PLE, which introduce long delay times. With this arrangement, the connections between the F/Fs make it possible to raise the operation frequency of the realised counter circuit and the like to a high speed.

Reference is made, by way of example, to the accompanying drawings, in which like reference characters designate the same or similar parts throughout the figures thereof and wherein:-

Fig. 1 is a circuit diagram of a PLE which can be used in the present invention;

Fig. 2 is a circuit arrangement diagram of a PLD showing an embodiment of the present invention;

Fig. 3 is a circuit diagram of a counter circuit realised by use of the PLD of Fig. 2;

Fig. 4 is a graph for comparing the effects of the Fig. 2 embodiment and a conventional example;

Fig. 5 is an arrangement diagram of a PLD;

Figs. 6 and 7 are circuit diagrams showing conventional examples;

Fig. 8 is a circuit arrangement diagram of a conventional PLD; and

Fig. 9 is a connection diagram in which the conventional PLD of Fig. 8 is used.

An embodiment of the present invention will now be described in detail with reference to the accompanying drawings, beginning with a description of Fig. 1 by way of background explanation.

Fig. 1 is a circuit diagram of a PLE which is similar to that shown in the above-mentioned Elektronik article and which can be adapted for use in the present invention. The PLE 1 includes a programmable combinational logic circuit 2, a plurality of D-type F/Fs 3 and selectors 4, and is assembled into a PLD as shown in Fig. 5.

The programmable combinational logic circuit 2 has a programmable logic array (hereinafter referred to as "PLA") including an AND plane or an OR plane, which have programmable product term lines, or a combinational logic circuit including memory for storing a logic specification per combination of inputs of input terminals 2a, to thereby obtain a logic output by a table look-up system. Outputs from the combinational logic circuit 2 are connected to independent combinational logical output terminals 5 and to one input 4a of input terminals of the selectors 4.

The selector 4 comprises two OR-connected n-channel MOS FETs, either one of which is programmed to be in an "on" state, so that an input into this one of the MOS FETs is selected as the output. This selected output is connected to a D input terminal of the F/Fs 3.

Connected to one 4a of the input terminals of the selectors 4 is an output from the combinational logic circuit 2, the other 4b of the input terminals being used as a F/F input terminal, to which an external input is supplied.

The F/Fs 3 each have clock input terminals (common or independent) 6 and F/F output terminals 7 which can output independently of each other. The F/Fs 3 are not limited to D types, and may be formed by other types.

The operation of the above-described circuit arrangement is as follows.

When inputs into the input terminals 4a on one side of the selectors 4, that is, outputs from the combinational logic circuit 2, are selected and applied to the D input terminals of the F/Fs 3, the outputs from the combinational logic circuit 2 are subjected to sampling by a clock and can be output from the output terminals 7 of the F/Fs 3.

When the input terminals 4b on the other side of the selector 4 are selected, in the F/Fs 3, outputs externally input from other logic elements are subjected to sampling by the clock and can be output from the output terminals 7 of the F/Fs 3. At this time, the outputs from the combinational logic circuit 2 can be output from combinational logic output terminals 5 provided independently of the output terminals 7 of the F/Fs 3. Namely, the combinational logic outputs can be used for independent purposes. Of course, since there are a plurality of F/Fs 3, some of the F/Fs 3 can be used for independent purposes and others can be connected to the output terminals of the combinational logic circuit 2 for combinational use. Furthermore, in the present invention, a shift circuit and the like can be formed by connecting the output terminal or terminals of the F/Fs 3 to the input terminal or terminals 4b of other ones of the F/Fs 3.

As described above, in using the F/Fs 3 and the combinational logic circuit 2, the freedom of connection is increased to allow greater flexibility, so that the remaining F/Fs in the PLE can be effectively utilised, thus improving the use efficiency.

An embodiment of the present invention will now be described in detail.

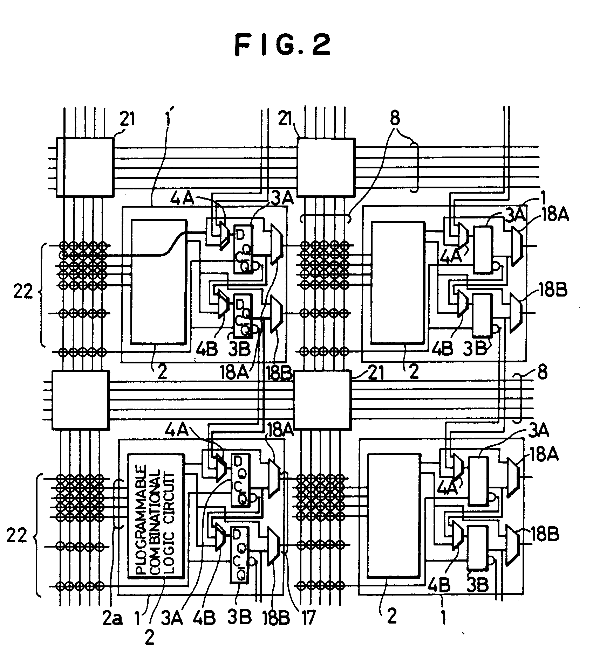

Fig. 2 is a circuit arrangement diagram of the PLD showing an embodiment of the present invention. This embodiment has a plurality of PLEs 1 and a plurality of programmable wirings 8 disposed in vertical and horizontal directions between the PLEs 1.

The PLE 1 has:-

a programmable combinational logic circuit 2 for producing optional combinational logic outputs in response to input signals 2a by programming;

two D-type F/Fs 3A and 3B;

input selectors 4A and 4B connected to the D input terminals of the two F/Fs 3A and 3B, respectively, providing selecting means for selecting input signals; and output selectors 18A and 18B for selecting either output signals from the F/Fs 3A and 3B or output signals from the programmable combinational logic circuit 2 to output the same to a plurality of (two in the drawing) output terminals 17, respectively.

Here, separately connected to some of the input terminals of the input selector 4A of a first F/F 3A are a non-inverted output signal Q and an inverted output signal $\overline{Q}$ from a second (last) F/F 3B of an adjoining PLE 1', and connected to the other input terminals of PLE 1 are output signals from its own programmable combinational logic circuit 2.

Furthermore, separately connected to some of the input terminals of the input selector 4B of the second F/F 3B are a non-inverted output signal Q and an inverted output signal $\overline{Q}$ from the first F/F 3A, and connected to the other input terminals are the other output signals from the programmable combinational logic circuit 2. The output signals Q and $\overline{Q}$ from the second F/F 3B are directly connected to input selectors of the first F/F of the further adjoining PLE, as necessary.

In the programmable wirings 8, switch arrays 21 are provided at intersections of the wirings disposed in vertical and horizontal directions. Input/output switch arrays 22 are provided at the intersections, and the above-described members are programmed respectively, so that the input signals to and the output signals from the respective PLEs 1 can be wired mutually and freely.

Clock signals to the clock input terminals C of the F/Fs 3A and 3B are connected to the programmable wirings 8 through input/output switches 22, whereby the clock signals are supplied from inside or outside of this PLD.

The operation of this embodiment will now be described.

Fig. 3 is a circuit diagram of a four-bit counter circuit which employs the Fig. 2 PLD. This counter circuit includes four D-type F/Fs 3A (3B), in which D input terminals are serially connected, an AND gate 30 and a NOR gate 34.

When this counter circuit is programmed on the PLD in this embodiment, the portions where the output terminals and the D input terminals of the F/Fs 3A (3B) are serially connected are directly connected to each other through the respective selectors 4A as indicated by solid lines in Fig. 2.

Fig. 4 is a graph comparing the effects of the above embodiment and the conventional example. An operation frequency A for the above circuit as implemented in CMOS, and an operation frequency B in a case where the above counter circuit is programmed on a PLD formed by CMOS in the conventional example as shown in Fig. 8, are plotted as a function of source voltage. In this embodiment, mutual connections between the input and output signals of the respective F/Fs can be made without passing through the programmable wirings or the programmable combinational logic circuit, which introduce relatively long delay times. As a result, an operation frequency of about 1.5 times that in the conventional example is obtained, as shown in the graph.

Incidentally, in the above embodiment, the D-type F/Fs may be replaced with F/Fs of other types and the number of F/Fs is not limited to two. Furthermore, it is clear that the same effects can be achieved regardless of whether the non-inverted output signal or the inverted output signal is used as the output signal of the F/Fs.

## Claims

1. A programmable logic device having a plurality of programmable logic elements (1, 1') capable of forming an optional logic circuit by programming of programmable links (8) connecting input terminals and output terminals of said programmable logic elements to each other, wherein:-

    said programmable logic elements have a combinational logic circuit (2); a number N of flip-flop circuits (3A, 3B ...) each of which has a selecting means (4A, 4B ...) for switching one of either (i) an output of the said combinational logic circuits (2) or (ii) an output from another programmable logic element (1') or (iii) an output of another flip-flop circuit (3B) of the same programmable logic element (1), to an input terminal of said flip-flop circuit (3A); and said programmable logic elements (1, 1') are provided with output terminals (5) connected to outputs of said combinational logic circuit (2) and output terminals (7) connected to outputs of each of said flip-flops (3A, 3B).

2. The device as set forth in claim 1, wherein said flip-flop circuits (3) are D-type flip-flop circuits.

3. The device as set forth in claim 1 or 2, wherein said combinational logic circuit (2) is a programmable combinational logic array including an AND plane and an OR plane, which has programmable product term lines.

4. The device as set forth in claim 1, 2 or 3, wherein said combinational logic circuit (2) has a memory for storing a logic specification per combination of inputs of input terminals, to thereby obtain a logic output by a table look-up system.

5. The device as set forth in any of claims 2 to 4, wherein said selecting means comprises a selector (4) comprising a plurality of OR-connected n-channel MOS FETs, any one of the MOS FETs being on-controlled programmably, so that an input to said one of the MOS FETs is alternatively selected to be output.

6. The device as set forth in any preceding claim, wherein said combinational logic circuit (2) and at least one flip-flop circuit (3) are used independently of each other.

7. The device as set forth in any preceding claim, wherein some of the input terminals of a preselecting means (4B) of the flip-flop circuit No. 1, where 2 ≤ I ≤ N, are connected to an output terminal of a flip-flop circuit No. I-1.

8. The device as set forth in any preceding claim, wherein an output signal of the flip-flop circuit No. N is further directly connected to input signal selecting means (4') of the flip-flop circuit No. 1 of another adjoining programmable logic element (1').

## Patentansprüche

1. Programmierbare logische Vorrichtung mit einer Vielzahl von programmierbaren logischen Elementen (1'), die zur Bildung eines optionalen logischen Schaltkreises durch Programmieren von programmierbaren Verbindungen (8) geeignet sind, die Eingangsanschlüsse und Ausgangsanschlüsse der genannten programmierbaren logischen Elemente miteinander verbinden,

**dadurch gekennzeichnet,**

daß die programmierbaren logischen Elemente einen logischen Kombinationsschaltkreis (2); eine Anzahl N von Flip-Flop-Schaltkreisen (3A, 3B...), deren jeder ein Wählmittel (4A, 4B...) zum Zuführen entweder (i) eines Ausgangssignals der genannten logischen Kombinationsschaltkreise (2) oder (ii) eines Ausgangssignals eines anderen programmierbaren logischen Elementes (1') oder (iii) eines Ausgangssignals eines anderen Flip-Flop-Schaltkreises (3B) desselben programmierbaren logischen Elementes (1) zu einem Eingangsanschluß des genannten Flip-Flip-Schaltkreises (3A) verfügt und daß die genannten programmierbaren logischen Elemente (1') mit Ausgangsanschlüssen (5), die an die Ausgänge des genannten logischen Kombinationsschaltkreises (2) angeschlossen sind, und mit Ausgangsanschlüssen (7) ausgestattet sind, die an Ausgänge jedes der genannten Flip-Flops (3A, 3B) angeschlossen sind.

2. Vorrichtung nach Anspruch 1, **dadurch gekennzeichnet,** daß die Flip-Flop-Schaltkreise (3) Flip-Flop-Schaltkreise des D-Typs sind.

3. Vorrichtung nach Anspruch 1 oder 2, **dadurch gekennzeichnet,** daß der genannte logische Kombinationsschaltkreis (2) ein programmierbares logisches Kombinationsfeld mit einer UND-Ebene und einer ODER-Ebene ist, die programmierbare Produktausdruck-Leitungen aufweisen.

4. Vorrichtung nach Anspruch 1, 2 oder 3, **dadurch gekennzeichnet,** daß der genannte logische Kombinationsschaltkreis (2) einen Speicher zur Speicherung einer logischen Spezifikation durch Kombination von Eingangssignalen der Eingangsanschlüsse aufweist, um dadurch ein logisches Ausgangssignal mittels eines Tabellen-Nachschlage-Systems zu erreichen.

5. Vorrichtung nach einem der Ansprüche 2 bis 4, **dadurch gekennzeichnet,** daß die genannten Wählmittel einen Selektor (4) mit einer Vielzahl von ODER-angeschlossenen n-Kanal MOS FET's umfassen, wobei jedes der MOS FET's programmierbar EIN-gesteuert ist, so daß ein Eingangssignal zu dem genannten einen der MOS FET's alternativ zur Abgabe ausgewählt ist.

6. Vorrichtung nach irgendeinem vorhergehenden Anspruch, **dadurch gekennzeichnet,** daß der genannte logische Kombinationsschaltkreis (2) und mindestens ein Flip-Flop-Schaltkreis (3) unabhängig voneinander verwendet sind.

7. Vorrichtung nach irgendeinem vorhergehenden Anspruch, **dadurch gekennzeichnet,** daß einige der Eingangsanschlüsse eines Vorauswahlmittels (4B) des Flip-Flop-Schaltkreises Nr. I, wobei gilt 2 ≤ I ≤ N, an einen Ausgangsanschluß eines Flip-Flop-Schaltkreises Nr. I-1 angeschlossen ist.

8. Vorrichtung nach irgendeinem vorhergehenden Anspruch, **dadurch gekennzeichnet,** daß ein Ausgangssignal des Flip-Flop-SchaltkreisesNr. N des weiteren direkt an ein Eingangssignal-Wählmittel (4A') des Flip-Flop-Schaltkreises Nr. 1 eines anderen benachbarten programmierbaren Elementes (1') angeschlossen ist.

**Revendications**

1. Dispositif logique programmable comportant plusieurs éléments logiques programmables (1, 1') capables de former éventuellement un circuit logique par programmation de liaisons programmables (8) reliant mutuellement des bornes d'entrée et des bornes de sortie desdits éléments logiques programmables, dispositif dans lequel:

- lesdits éléments logiques programmables comportent un circuit logique de combinaison (2) ; un nombre N de circuits formant bascules (3A, 3B...) comportant chacun un moyen de sélection (4A, 4B...) pour transmettre l'un des signaux constitués par (i) un signal de sortie dudit circuit logique de combinaison (2) ou (ii) un signal de sortie d'un autre élément logique programmable (1') ou (iii) un signal de sortie d'un autre circuit formant bascule (3B) du même élément logique programmable (1), à une borne d'entrée dudit circuit formant bascule (3A) ; et lesdits éléments logiques programmables (1, 1') sont pourvus de bornes de sortie (5) reliées à des sorties dudit circuit logique de combinaison (2) ainsi que des bornes de sortie (7) reliées à des sorties de chacune desdites bascules (3A, 3B).

2. Dispositif selon la revendication 1, dans lequel lesdits circuits formant bascules (3) sont des bascules de type-D.

**3.** Dispositif selon la revendication 1 ou 2, dans lequel ledit circuit logique de combinaison (2) est un ensemble logique de combinaison programmable comprenant un plan ET ou un plan OU, qui comporte des lignes de termes de produits programmables.

**4.** Dispositif selon la revendication 1, 2 ou 3, dans lequel ledit circuit logique de combinaison (2) comprend une mémoire pour mémoriser une spécification logique par combinaison de signaux d'entrée à des bornes d'entrée de façon à obtenir ainsi une sortie logique par un système de consultation de table.

**5.** Dispositif selon une quelconque des revendications 2 à 4, dans lequel ledit moyen de sélection comprend un sélecteur (4) comportant plusieurs transistors à effet de champ de type MOS, à canal-n et à connexion -OU, l'un quelconque des transistors de type MOS étant rendu conducteur de façon programmable de telle sorte qu'un signal d'entrée appliqué à l'un des transistors de type MOS soit alternativement sélectionné comme un signal de sortie.

**6.** Dispositif selon une quelconque des revendications précédentes, dans lequel ledit circuit logique de combinaison (2) et au moins un circuit formant bascule (3) sont utilisés indépendamment l'un de l'autre.

**7.** Dispositif selon une quelconque des revendications précédentes, dans lequel certaines des bornes d'entrée d'un moyen de présélection (4B) du circuit formant bascule n° I, où $2 \leq I \leq N$, sont reliées à une borne de sortie d'un circuit formant bascule n° I-1.

**8.** Dispositif selon une quelconque des revendications précédentes, dans lequel un signal de sortie du circuit formant bascule n° N est en outre relié directement à un moyen de sélection de signal d'entrée (4A') du circuit formant bascule n° 1 d'un autre élément logique programmable adjacent (1').

# FIG. 1

4b  F/F INPUT

1

PLE

2

5

COMBINATIONAL LOGIC  OUTPUT

4

2a

INPUTS

COMBINATIONAL LOGIC CIRCUIT

D      Q

F/F

7

F/F OUTPUT

4a

CK

3

6

5

CLOCK

COMBINATIONAL LOGIC  OUTPUT

4a

D      Q

F/F

7

F/F OUTPUT

4

CK

4b  F/F INPUT

# FIG.2

# FIG. 3

# FIG. 4

# FIG. 5

# F I G. 6

# F I G . 7

# FIG.8

EP 0 317 287 B1

F I G. 9